# EUROPEAN PATENT SPECIFICATION

(11) **EP 1 227 563 B1**
(45) Date of publication and mention of the grant of the patent: **12.04.2017**
(21) Application number: 01310890.7
(22) Date of filing: 24.12.2001
(51) Int. Cl.: H02J 7/00, H02J 7/04, H02J 7/16, G01R 31/36, H01M 10/44, H02M 1/00

(54) **Method for charging a battery**
Verfahren zur Ladung einer Batterie
Méthode de recharge d'une batterie

(30) Priority: 29.12.2000 US 259110; 29.01.2001 US 772249
(43) Date of publication of application: 31.07.2002
(73) Proprietor: Nytell Software LLC, Wilmington DE 19808 (US)
(72) Inventor: Ruha, Antti, 90550 Oulu (FI); Ruotsalainen, Tarmo, 90570 Oulu (FI); Tervaluoto, Jussi-Pekka, 90570 Oulu (FI); Kauppinen, Jani, 90230 Oulu (FI)
(74) Representative: Small, Gary James

(56) References cited:
- EP-A- 0 711 016
- EP-A- 0 993 103
- US-A- 5 773 963
- US-A- 5 977 751
- US-A- 6 154 012

## Description

### FIELD OF THE INVENTION:

This invention relates generally to battery charging circuitry and methods and, more particularly, relates to methods and apparatus for measuring a battery charging current, as well as a battery discharging current.

### BACKGROUND OF THE INVENTION:

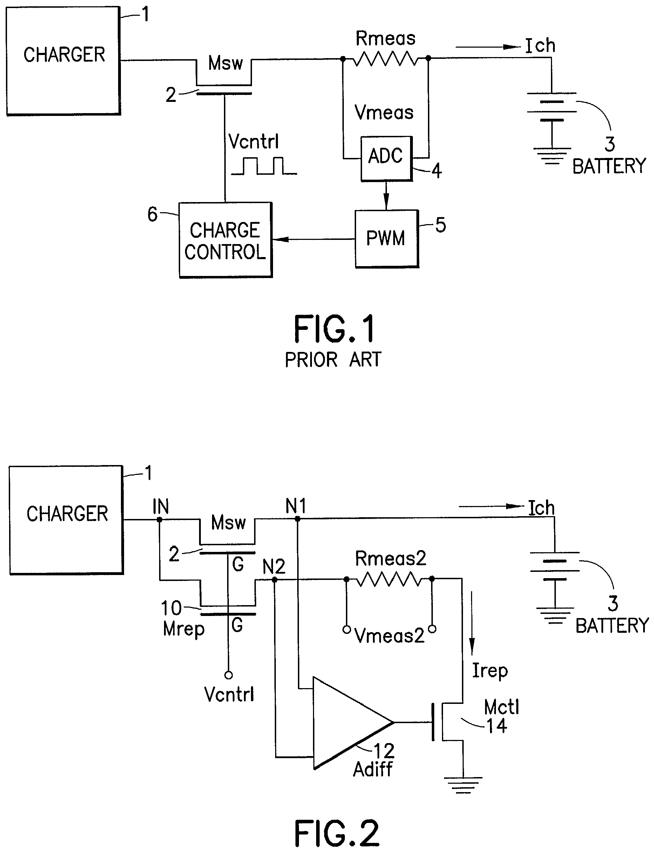

A battery charging circuit of most interest to these teachings is one used with a wireless terminal, also referred to as mobile station or as a personal communicator. During a charging operation a relatively high current is required to be measured and monitored, typically in the range of several hundred milliamps (mA) or even more. Referring to Fig. 1, conventional practice places a series resistance (Rmeas) between a source of charging current, shown as a charger 1, and the associated charger switch (Msw) 2. Msw is coupled to the battery 3 to be recharged. The battery charging current (Ich) flows through Rmeas, and the resulting voltage drop (Vmeas) across Rmeas is sensed for controlling the charging cycle. For example, an analog-to-digital converter (ADC) 4 may be used to convert Vmeas to an a digital representation, which in turn may be used to modulate the pulse width of a signal output from a pulse width modulator (PWM) 5. Vmeas may also be employed as a measurement of the battery voltage. The output of the PWM 5 can be used directly, or it can be further modified by a charging controller 6, to provide a switching signal (Vcntrl) to Msw. In this way the conduction through Msw is varied so that as the battery 3 reaches full charge the on-time or Msw can be gradually reduced until finally Msw is supplying only a maintenance (trickle) charge to the battery 3. In other embodiments the feedback loop from Rmeas to Vcntrl could be implemented in an entirely analog fashion, or in a mixed analog/digital fashion.

One significant drawback to the use and operation of this type of conventional charging circuit is that Rmeas is required to be a low ohmic value, high precision resistor. Due to the significant current flow through Rmeas it must also be large physically in order to dissipate the resulting heat. The use of a physically large resistor implies that a separate, discrete component be used, as opposed to an integrated component, which increases the cost as well as the complexity of the manufacturing and testing operations. Furthermore, Rmeas must be carefully located so as not to excessively heat adjacent circuit components. In addition, because of the low ohmic value of Rmeas the resulting voltage drop Vmeas is also small, which can require the use of high resolution ADC 4 to obtain an accurate measurement of Ich.

Charging arrangements are known from US6154012, US59777651, US5773963,
EP0993103 and EP0711016. In US6154012 there is disclosed a circuit that measures a mirror current passing through an input as a battery charges. The circuit includes a power transistor and a sense transistor. The circuit further includes a comparator, a voltage source, a first transistor, and a second transistor. The negative terminal of comparator is coupled to a negative terminal of the battery, and the positive terminal of comparator is coupled to the input through which the mirror current travels. The negative terminal of the battery is coupled to the source of power transistor. The current used to charge the battery passes through power transistor. The input through which the mirror current travels is coupled to the source of the sense transistor. The input through which the mirror current travels is also coupled through the first transistor to the voltage source.

Copending U.S. Patent Application Serial No.; 09/772,249, filed on 29 January 2001, published on 18 June 2002 (publication number: US6407532B1), entitled Method and Apparatus for Measuring Battery Charge and Discharge Current, by Antti Ruha (hereinafter referred to simply as the parent application), discloses various embodiments of circuitry that enable the resistance Rmeas to be eliminated and to relax the ADC conversion range. It is thus desirable to provide even further improvements to simplify the current measurement and conversion functions.

### OBJECTS AND ADVANTAGES OF THE INVENTION:

It is a first object and advantage of this invention to provide an improved battery energy management circuit.

It is another object and advantage of this invention to provide an improved battery charging circuit for use in a wireless terminal that overcomes the foregoing and other problems, and that provides a direct analog-to-digital conversion function whereby a value of the charge/discharge current can be realized in a digital fashion.

It is a further object and advantage of this invention to provide an improved battery discharging circuit for use in making battery capacity and other types of measurements.

### SUMMARY OF THE INVENTION

In accordance with the present invention, there is provided a method and apparatus as defined by claims 1 and 7.

### BRIEF DESCRIPTION OF THE DRAWINGS

The above set forth and other features of the invention are made more apparent in the ensuing Detailed Description of the Invention when read in conjunction with the attached Drawings, wherein:
Fig. 1 is a circuit diagram, partially in block diagram form, that depicts a conventional battery charger arrangement;
Fig. 2 is a circuit diagram, partially in block diagram form, that depicts a battery charger circuit in accordance with the teachings of the parent application;
Fig. 3 shows an alternate configuration of the measurement resistor and servo loop transistor Mctl of Fig. 2;
Fig. 4 is a circuit diagram, partially in block diagram form, that depicts a battery discharge circuit in accordance with the teachings of the parent application;
Fig. 5 is a block diagram of current measurement circuitry in accordance with this invention, wherein a replica of a current to be measured is digitized directly;
Figs. 6A, 6B and 6C each depict an embodiment of the lowpass filter block of Fig. 5, specifically a simplest resistor/capacitor (RC) version, an active RC version and a switched capacitor (SC) version, respectively;
Fig. 7 shows an embodiment of the current steering DAC of Fig. 5; and
Fig. 8 shows an embodiment of the digital filter of Fig. 5,

### DETAILED DESCRIPTION OF THE PREFERRED EMBODIMENTS

By way of introduction, reference is first made to Fig. 2 for showing a circuit diagram, partially in block diagram form, of a battery charger circuit in accordance with the teachings of the parent application. Elements that are also found in Fig. 1 are numbered accordingly.

In Fig. 2 a scaled down replica of the charging current Ich, designated Irep, is generated with the aid of a servo-control circuit embodied as components Mrep 10, Adiff 12 and Mctl 14. The current Irep, not Ich, is passed through a measurement resistor Rmeas2. The replica of the charging current Irep is an accurate representation of the actual charging current Ich, as Msw 2 and Mrep 10 have the same terminal potentials at their respective input nodes, as well as at their respective output nodes (N1 and N2). That is, both of the transistors Msw 2 and Mrep 10 see the same voltage at their input terminal and at their gate (G) terminal (or Vcntl), and their respective outputs (N1 and N2) are at the same voltage potential due to the feedback formed by the servo-circuit. More particularly, the differential amplifier Adiff 12, which outputs a difference signal representing the difference between the potentials appearing at nodes N1 and N2, in combination with transistor Mctl 14, forces the potential at node N2 to equal the potential at node N1, As a result, Irep equals Ich/N, where N is a scaling factor or ratio that is described next.

The current scaling is achieved by reducing the size (the channel Width/Length ratio of a MOS transistor) of the current replicating transistor or device Mrep 10 by the scaling factor or ratio N with respect to the Width/Length ratio of the charging transistor or device Msw 2. In general, N is greater than unity. Preferably, N is greater than about 10, and more preferably is greater than about 100. Most preferably, the scaling factor or ratio (N) is in a range on the order of, for example, about 100 to about 1000.

Since the current scales linearly with the transistor channel geometry and assuming, by example, a scaling factor of 500: for a 200 mA charging current Ich the replication current Irep is only 400 micro amps (400 µA). This significant reduction in current flow through the measurement or sense resistance Rmeas2 enables a significantly larger ohmic value to be used for Rmeas2 (relative to the prior art circuit of Fig. 1), and further provides significantly less power dissipation. For example, a value of 1.5kΩ for Rmeas2 yields a value of 600 mV for Vmeas2, assuming a value for Irep of 400 µA. A 10-bit ADC 4 is thus clearly suitable for accurately digitizing the magnitude of Vmeas2, and its implementation is facilitated by due to the increased voltage to be measured.

This procedure also enables a significantly smaller sized physical resistance element to be employed. The use of a smaller physical resistor element enables the resistor to be integrated into, for example, an energy management integrated circuit, thereby eliminating the requirement to provide a separate physical resistor. When the integrated resistance is employed for Rmeas2 it may be desirable to provide either analog/resistor calibration or digital calibration of the output of the ADC 4.

In various embodiments the charging transistor Msw, the current replication transistor Mrep and the control device Mctl can be NMOS-type devices, or PMOS-type devices, and may further be either NPN or PNP devices. With bipolar junction transistors (BJTs) the replica current scaling is achieved with appropriate ratioing of the charging transistor Msw and the current replication transistor Mrep emitter areas. All of these variations can be made to function according to these teachings by providing the corresponding suitable polarity for the differential amplifier Adiff 12. The optimum choice of device type is, in general, application and semiconductor technology dependent.

In the embodiment shown in Fig. 2 a floating sense amplifier (not shown) is preferably employed for buffering Vmeas2 prior to application to the ADC 4 (shown in Fig. 1).

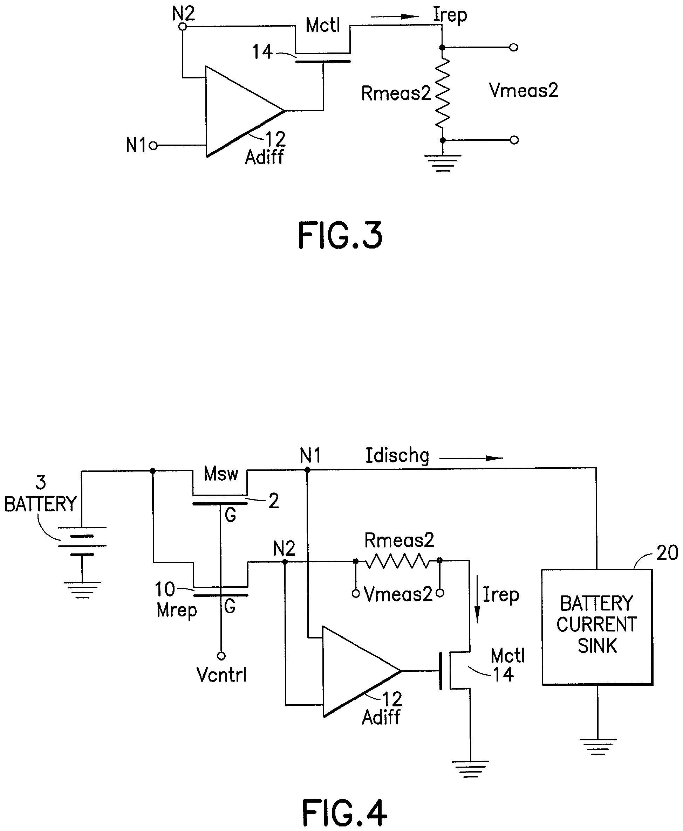

The position of the measurement resistor Rmeas2 and the control device Mctl can also be interchanged to realize a single-ended measurement of Vmeas2, as depicted in the embodiment shown in Fig. 3.

The following Table is useful in explaining the distinctions between the conventional charger arrangement shown in Fig. 1 and the charger arrangement of Fig. 2.

**TABLE**

| Power dissipation in measurement resistors and AD conversion voltage range (Fig. 1) | |
|---|---|
| Power dissipation in Rmeas: | Pdis=Ich*Ich*Rmeas |
| Voltage range: | Vrange=Ich*Rmeas |

| Power dissipation in measurement resistors and AD conversion voltage range (Fig. 2) | |
|---|---|
| Power dissipation in Rmeas2: | Pdis=Ich/N*Ich*Rmeas*M=Irep*Irep*Rmeas2 |
| Voltage range: | Vrange=Ich/N*Rmeas*M=Irep*Rmeas2 |

In the presently preferred embodiment the power dissipation in the measurement resistor (Rmeas2) and the voltage range can be chosen independently using the scaling of the current replication transistor Mrep 10 (by N) and the measurement resistor Rmeas2 (by M). It is thus possible to simultaneously realize a low power dissipation and a wide voltage range by selecting the scaling factors accordingly. The low power dissipation in Rmeas2 enables a physically smaller sized external or integrated resistor to be used, while the increased measurement voltage range relaxes the offset and accuracy requirements of the sense amplifier and the ADC 4 converter. A suitable number of bits of resolution for the ADC 4 is 10 bits, although more or less than 10 bits can be employed.

Referring now to Fig. 4, it should further be appreciated that these teachings apply as well to techniques for performing a discharge test on the battery 3, wherein the battery 3 sources current towards a circuit to be powered 20 which functions as a current sink for the current sourced by the battery 3. In all other respects the discharge circuit can be constructed in accordance with the embodiment shown in Fig. 2, or in accordance with the single-ended measurement embodiment shown in Fig. 3. During the discharge test the measurement resistance Rmeas2 is used to sense the battery discharge current (Idisch), which is reflected in the magnitude of Vmeas2. The discharge current, in combination with a measurement of the voltage across the battery 3, is useful for predicting the amount of battery capacity that remains. In this embodiment the battery discharge current can be reduced, if needed, during the discharge test.

It is pointed out that the charger transistor or device Msw and the replication transistor or device Mrep can be operated by Vcntrl in a switched fashion so that they are turned on and off by Vcntrl, However, it is also within the scope of these teachings to operate charger transistor or device Msw and the replication transistor or device Mrep in their linear modes (i.e., not switched off and on). In this case Vcntrl is generated as a DC voltage with an adjustable voltage value to vary the conduction through Msw and Mrep. However, this latter option maybe less desirable for some applications, as operation in the linear mode will generally consume more power and generate more heat than operation in the switched mode, as is well known.

Having thus reviewed the disclosure of the parent patent application, a description is now provided of additional embodiments in accordance with the teachings of this invention.

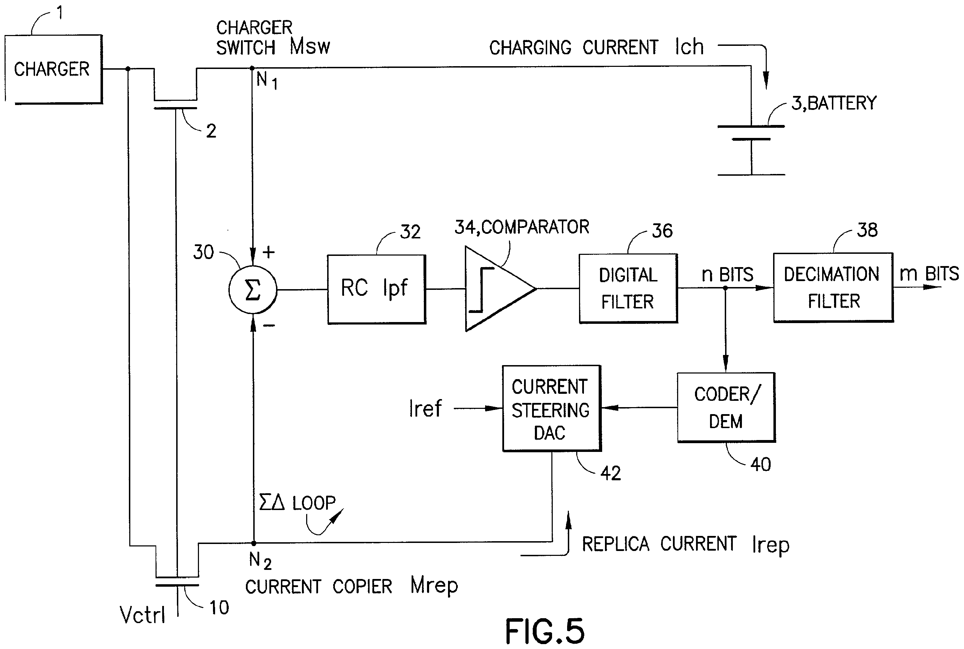

Reference is now made to Fig. 5 for showing a circuit diagram, partially in block diagram form, of a battery charger circuit in accordance with the teachings of this invention. Elements that are also found in Figs. 1, 2, 3 and 4 are numbered accordingly.

In the presently preferred embodiment of the charge current measurement circuit a scaled down replica of the charging current is generated with the aid of a sigma-delta loop 28 containing current replication or copier transistor Mrep 10, a low pass filter (lpf) 32 fed from a summing junction 30, a comparator 34, a digital filter 36, a coder/Dynamic Element Matching (DEM) block 40, and a current steering DAC 42. An accurate (and scaled down) replica of the charging current Irep is generated and flows through the current copier transistor (Mrep) 10, when the devices Msw 2 and Mrep 10 have the same terminal potentials. Both of these devices have the same voltage at the input terminal and at the gate terminal, and the output terminal of Mrep 10 is forced to be at the same potential as that of Msw 2 (in an average sense).

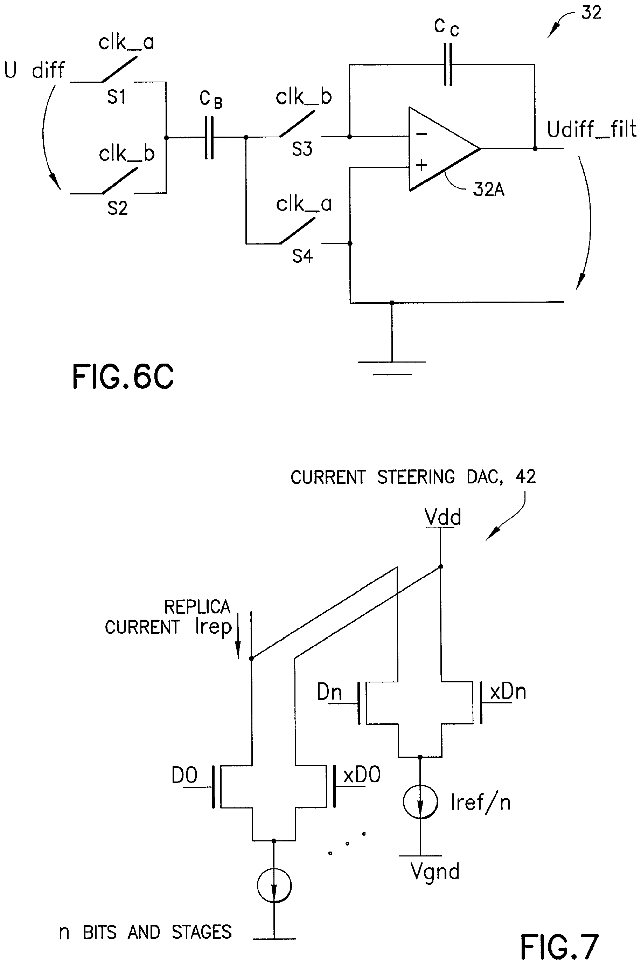

The current scaling is achieved by making the size (W/L ratio) of the Mrep 10 to scaled down by a factor of N with respect to the charging switch Msw 2, as was described above. The charging switch Msw 2 and the current copier transistor Mrep 10 may be either NMOS or PMOS (NPN or PNP) types. The feedback DAC 42 may be implemented using either NMOS or PMOS (NPN or PNP) devices, for example, in the current steering structure shown in Fig. 7. All of these variations in the design can be made to function according to these teachings by providing suitable polarities of the signal voltages and currents. The optimum choice of device types is application and semiconductor technology dependent, as will be appreciated by those skilled in the art.

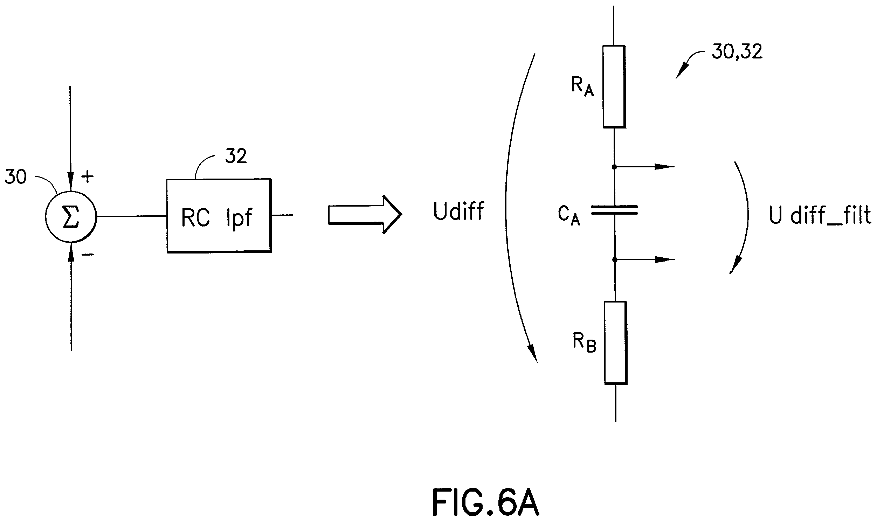

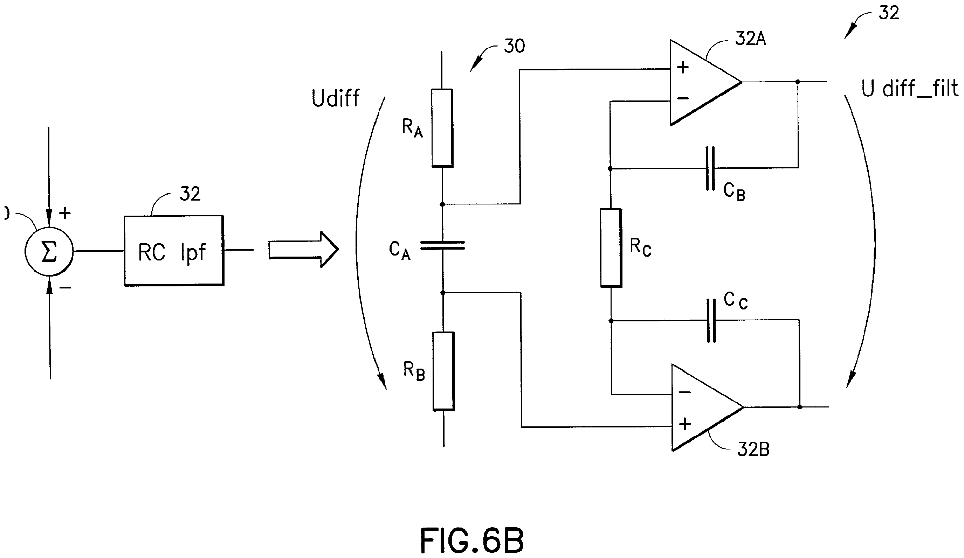

The low pass filter (lpf) 32 smooths out and averages the voltage differences (Udiff) between the output terminals (N1 and N2) of Msw 2 and Mrep 10, producing Udiff_filtered. The lpf 32 can be either single ended or differential in construction. The lpf 32 may be simply a differential passive RC network as shown in Fig. 6A, where it is comprised of summing node 30 resistors R_{A} and R_{B} in combination with capacitor C_{A}, or it may be implemented with an active RC filter of first or higher order (to improve the performance of the measurement sigma-delta loop), as shown in Fig. 6B. In Fig. 6B the differential RC lpf 32 includes amplifiers 32A, 32B, in combination with feedback network R_{C}, C_{B} and C_{C}. In a further embodiment of this invention shown in Fig. 6C the summing node 30 and the lpf 32 is not an RC structure at all, but is instead a switched capacitor (SC) embodiment constructed with phase clock a (clk_a) switches S1 and S4, phase clock b (clk_b) switches S2 and S3, capacitors C_{B} and C_{C}, and amplifier 32A. The construction and operation of such active RC and SC based low pass filters, in both single ended and differential topologies, is well known in the art.

For the RC lpf embodiments of Figs. 6A and 6B the accuracy of the resistors need not to be high, but the resistors are preferably matched to within a few percent (depending on the desired measurement accuracy). Resistor matching to within a few percent is readily achieved when the resistors are integrated using typical integrated circuit layout techniques. A mismatch results in a gain error that can be calibrated either in the analog or the digital domain if high accuracy is required. No special resistor layers in a silicon process are required, and conventional well-type or diffusion-type resistors are adequate for most applications. In addition to the SC embodiment of Fig. 6C, the low-pass filter 32 can also be constructed with transconductors (gm-C techniques), or with SI (switched current) circuitry to avoid the use of resistors altogether.

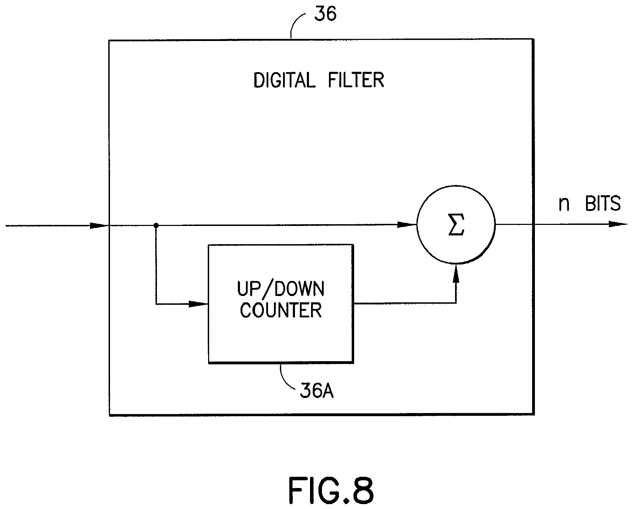

The comparator 34 detects the sign of the relative magnitudes at the output terminals in an over-sampled fashion, and the resulting one bit comparator output signal increases or decreases the value at the output of the digital loop filter 36. In general, the digital loop filter 36 outputs a value that increments or decrements as a function of a voltage difference between nodes N1 and N2. In the presently preferred embodiment the digital loop filter 36 is constructed using an up/down counter 36A, as shown in Fig. 8. The value output from the comparator 34 controls the counting direction (up or down) of the up/down counter 36A, and the resulting value output from the digital loop filter 36 is used to switch a corresponding number of DAC 42 stages to sink the current from the replica transistor Mrep 10 so that the voltage difference between nodes N1 and N2 is minimized.

Referring also to Fig. 7, in operation the output current value of the DAC 42 is equal to the counter 36 output value multiplied by Iref divided by n (the number of stages). The DAC 42 preferably contains a number of current steering DAC stages. The exact number of stages is application specific. As an example, with 16 DAC stages (∼4 bits) a better than 10% one-sample resolution is achieved. The reference current Iref defines the measurement range, and is dimensioned so that the total sinking capability of the DAC 42 is equal to the maximum charge current (Ich_max) divided by the mirroring ratio N (i.e., Iref is equal to Ich_max divided by the scaling factor between Msw 2 and Mrep 10).

The Coder/Dem block 42converts the output word format of the digital filter 36 to a temperature format, and the DEM (dynamic element matching) logic selects which DAC stages are to sink the current. The purpose of the DEM is to average out the possible mismatching of the DAC 42 stages in order to improve the linearity.

It is known to use DEM techniques in the context of sigma-delta converters. Reference in this regard can be made to, for example, U.S. Patent No.: 5,990,819, "D/A converter and delta-sigma D/A converter", by Fujimori and to U.S. Patent No.: 6,011,501, "Circuits, systems and methods for processing data in a one-bit format", by Gong et al. Reference with regard to the DEM technique can be made to chapter 8.3.3 of "Delta-Sigma Data Converters", S. Norsworthy, R. Scherier, G. Temes, IEEE Press (1997), incorporated by reference herein. Dynamic element matching and sigma-delta modulator techniques are both generally well known in the art. The function of the DEM is to operates the switches of the current steering DAC 42 on a random (or a pseudorandom) selection basis so as to randomly distribute the signals forming the thermometer code from the Coder element amongst the *n* stages of the current steering DAC 42.

The (optional) decimation filter 38 functions to smooth out the "coarse" quantization of the sigma-delta loop 28, and improves the measurement accuracy by averaging several quantization results. Decimation is commonly used in conjunction of sigma-delta modulators and over-sampling. In this application the decimation (or more generally the averaging) function can be implemented with hardware integrated on the same integrated circuit, or in energy management and charging software.

At least one end result of the operation of the circuitry shown in Fig. 5 is to generate the control signal (Vcntl) to be one of the pulse width modulated (PWM) signal having a pulse width that is controlled as a function of the digital output of the closed loop current sink (in addition to a specific battery charging algorithm), or a DC voltage having an adjustable voltage value that is controlled as a function of the digital output of the closed loop current sink (in addition to a specific battery charging algorithm). In this manner the value of Ich is set at an appropriate value for charging the battery 3.

It should be appreciated that these teachings apply as well to the techniques for performing a discharge test on the battery 3, wherein the battery 3 sources current towards a circuit to be powered 20 which functions as a current sink for the current sourced by the battery 3. That is, the current measuring technique in accordance with this invention can be used as well in the circuitry shown in Fig. 4.

While the teachings of this invention have been described in the context of a battery charging circuit used in a wireless terminal, such as a cellular telephone or a personal communicator, those skilled in the art will appreciate that these teachings are not limited to only this one important application, but can instead be employed in a wide range of devices powered by a rechargeable battery, such as personal digital assistants, laptop and notebook computers, and various types of toys.

More generally, these teachings have broad applicability in the field of the measurement of current and the conversion of the measured current value to a digital representation. The invention can be used in any application were a current to be measured is flowing through a switch, such as a transistor, and is, for example, particularly useful in the measurement of the charging current of the battery in a wireless terminal such as a mobile phone. However, the teachings in accordance with this invention can be utilized in other current and power measurement applications, such as in power regulators, power amplifiers and in motor controls, without requiring that resistance be added into the current path. These teachings are also applicable to impedance measurements and, for example, to the detection of high current and short circuit situations. Thus, while these teachings have been described in the context of making a battery charge current measurement, this embodiment should be viewed as being exemplary, and not as being a limitation upon the practice of the teachings of this invention.

As such, while the invention has been particularly shown and described with respect to preferred embodiments thereof, it will be understood by those skilled in the art that changes in form and details may be made therein without departing from the scope of the invention.

## Claims

1. A method for charging a battery, comprising:
generating at a first node a battery charge current I_{charge} for charging the battery;
generating at a second node a replica current Iᵣₑₚ from I_{charge}, where Iᵣₑₚ<I_{charge};operating a closed loop current sink for sinking Iᵣₑₚ, where a digital output of said closed loop current sink is a measure of the magnitude of I_{charge}; and
wherein the operating comprises measuring a voltage drop (Vₘₑₐₛ₂) across a measurement resistance (Rₘₑₐₛ₂) due to a current flow Iᵣₑₚ through said measurement resistance.

2. A method as in claim 1, where said digital output is input to a control circuit for controlling the generation of I_{charge}.

3. A method as in claim 1, where said closed loop current sink is comprised of a multi-stage DAC (42) driven by an output of a digital loop filter (36) that increments or decrements as a function of a voltage difference between said first node and said second node.

4. A method as in claim 3, where a selection of stages of the multi-stage DAC to be turned off and on is made by a dynamic element matching DEM logic block (40) that is interposed between the output of said digital loop filter (36) and said multi-stage DAC (42).

5. A method as in claim 3, where said digital loop filter (36)is comprised of an up/down counter (36A), and where said multistage DAC is comprised of a multi-stage current steering DAC.

6. A method as in claim 1, and further comprising a step of decimating the digital output of said closed loop current sink.

7. A circuit for use in charging a battery, comprising a transistor (2) for providing at a first node (N1) a battery charge current I_{charge} for charging the battery;
a replicating circuit for generating at a second node (N2) a replica current Iᵣₑₚ from I_{charge}, where Iᵣₑₚ<I_{charge}; and
a closed loop current sink for sinking Iᵣₑₚ, where a digital output of said closed loop current sink is a measure of the magnitude of I_{charge};
wherein the closed loop current sink comprises a measurement resistance (Rₘₑₐₛ₂) across which a voltage drop (Vₘₑₐₛ₂) due to a current flow Iᵣₑₚ through said measurement resistance is measured.

8. A circuit as in claim 7, where said digital output is input to a control circuit for controlling the generation of I_{charge}.

9. A circuit as in claim 7, where said closed loop current sink is comprised of a multi-stage DAC (42) driven by outputs of a digital loop filter (36) having an output that increments or decrements as a function of a voltage difference between said first node (N1) and said second node (N2).

10. A circuit as in claim 9, where a selection of stages of the multi-stage DAC (42) to be turned off and on is made by a dynamic element matching DEM logic block (40) that is interposed between the output of said digital loop filter and said multi-stage DAC (42).

11. A circuit as in claim 9, where said digital loop filter (36) is comprised of an up/down counter (36A), and where said multi-stage DAC is comprised of a multi-stage current steering DAC.

12. A circuit as in claim 7, and further comprising a decimation filter (38) coupled to said digital output of said closed loop current sink.

13. A circuit as in claim 9, and further comprising a filter having a differential input coupled to said first and second nodes, said filter comprising one of a single ended output or a differential output coupled to an input of a comparator, said comparator having an output coupled to an input of said digital loop filter.

## Patentansprüche

1. Verfahren zum Aufladen einer Batterie, das Folgendes umfasst:
Erzeugen, an einem ersten Knoten, eines Batterieladestroms I_{charge} zum Laden der Batterie;
Erzeugen, an einem zweiten Knoten, eines Replikastroms Iᵣₑₚ von I_{charge}, wobei Iᵣₑₚ<I_{charge} ist;
Betreiben eines geregelten Stromabflusses zum Ableiten von Iᵣₑₚ, wobei eine digitale Ausgabe des geregelten Stromabflusses ein Maß für die Größe von I_{charge} ist; und
wobei das Betreiben das Messen eines Spannungsabfalls (Vₘₑₐₛ₂) über einem Messwiderstand (Rₘₑₐₛ₂), aufgrund eines Stromflusses Iᵣₑₚ durch den Messwiderstand, umfasst.

2. Verfahren nach Anspruch 1, wobei die digitale Ausgabe eine Eingabe für eine Regelschaltung zum Regeln der Erzeugung von I_{charge} ist.

3. Verfahren nach Anspruch 1, wobei der geregelte Stromabfluss aus einem Mehrstufen-DAC (42) besteht, der von einer Ausgabe eines digitalen Schleifenfilters (36) angesteuert wird, die stufenweise als Funktion einer Spannungsdifferenz zwischen dem ersten Knoten und dem zweiten Knoten erhöht oder erniedrigt wird.

4. Verfahren nach Anspruch 3, wobei eine Auswahl von aus- und einzuschaltenden Stufen des Mehrstufen-DACs durch einen Dynamischer-Element-Abgleich-DEM-Logikblock (40) vorgenommen wird, der zwischen den Ausgang des digitalen Schleifenfilters (36) und den Mehrstufen-DAC (42) zwischengeschaltet ist.

5. Verfahren nach Anspruch 3, wobei der digitale Schleifenfilter (36) aus einem Hoch-/Runterzähler (36A) besteht und wobei der Mehrstufen-DAC aus einem Mehrstufen-Stromsteuer-DAC besteht.

6. Verfahren nach Anspruch 1 und ferner umfassend einen Schritt des Dezimierens der digitalen Ausgabe des geregelten Stromabflusses.

7. Schaltung zur Verwendung beim Laden einer Batterie, umfassend einen Transistor (2) zum Bereitstellen, an einem ersten Knoten (N1), eines Batterieladestroms I_{charge} zum Laden der Batterie;
eine Replikationsschaltung zum Erzeugen, an einem zweiten Knoten (N2), eines Replikastroms Iᵣₑₚ von I_{charge}, wobei Iᵣₑₚ<I_{charge} ist; und
einen geregelten Stromabfluss zum Ableiten von Iᵣₑₚ, wobei eine digitale Ausgabe des geregelten Stromabflusses ein Maß für die Größe von I_{charge} ist;
wobei der geregelte Stromabfluss einen Messwiderstand (Rₘₑₐₛ₂) umfasst, über dem ein Spannungsabfall (Vₘₑₐₛ₂), aufgrund eines Stromflusses Iᵣₑₚ durch den Messwiderstand, gemessen wird.

8. Schaltung nach Anspruch 7, wobei die digitale Ausgabe eine Eingabe für eine Regelschaltung zum Regeln der Erzeugung von I_{charge} ist.

9. Schaltung nach Anspruch 7, wobei der geregelte Stromabfluss aus einem Mehrstufen-DAC (42) besteht, der von Ausgaben eines digitalen Schleifenfilters (36) angesteuert wird, der eine Ausgabe aufweist, die stufenweise als Funktion einer Spannungsdifferenz zwischen dem ersten Knoten (N1) und dem zweiten Knoten (N2) erhöht oder erniedrigt wird.

10. Schaltung nach Anspruch 9, wobei eine Auswahl von aus- und einzuschaltenden Stufen des Mehrstufen-DACs (42) durch einen Dynamischer-Element-Abgleich-DEM-Logikblock (40) vorgenommen wird, der zwischen den Ausgang des digitalen Schleifenfilters und den Mehrstufen-DAC (42) zwischengeschaltet ist.

11. Schaltung nach Anspruch 9, wobei der digitale Schleifenfilter (36) aus einem Hoch-/Runterzähler (36A) besteht und wobei der Mehrstufen-DAC aus einem Mehrstufen-Stromsteuer-DAC besteht.

12. Schaltung nach Anspruch 7 und ferner umfassend einen Dezimierungsfilter (38), der mit dem digitalen Ausgang des geregelten Stromabflusses gekoppelt ist.

13. Schaltung nach Anspruch 9 und ferner umfassend einen Filter, der einen Differenzeingang aufweist, der mit dem ersten und dem zweiten Knoten gekoppelt ist, wobei der Filter einen asymmetrischen oder einen Differenzausgang umfasst, der mit einem Eingang eines Komparators gekoppelt ist, wobei der Komparator einen Ausgang aufweist, der mit einem Eingang des digitalen Schleifenfilters gekoppelt ist.

## Revendications

1. Procédé pour charger une batterie, comprenant :
la génération, au niveau d'un premier noeud, d'un courant de charge de batterie I_{charge} pour charger la batterie ;
la génération, au niveau d'un deuxième noeud, d'un courant Iᵣₑₚ répliqué d'I_{charge}, où Iᵣₑₚ < I_{charge} ;
l'exécution d'un écoulement de courant à boucle fermée pour écouler Iᵣₑₚ, où une sortie numérique dudit écoulement de courant à boucle fermée est une mesure de l'amplitude d'I_{charge} ; et
dans lequel l'exécution comprend la mesure d'une chute de tension (Vₘₑₐₛ₂) aux bornes d'une résistance de mesure (Rₘₑₐₛ₂) due à une circulation de courant Iᵣₑₚ dans ladite résistance de mesure.

2. Procédé selon la revendication 1, dans lequel ladite sortie numérique est délivrée en entrée à un circuit de commande pour commander la génération d'I_{charge}.

3. Procédé selon la revendication 1, dans lequel ledit écoulement de courant à boucle fermée est constitué d'un DAC à étages multiples (42) entraîné par une sortie d'un filtre à boucle numérique (36) qui incrémente ou décrémente en fonction d'une différence de tension entre ledit premier noeud et ledit deuxième noeud.

4. Procédé selon la revendication 3, dans lequel une sélection d'étages du DAC à étages multiples devant être mis hors service et en service est effectuée par un bloc logique d'adaptation d'élément dynamique DEM (40) qui est interposé entre la sortie dudit filtre à boucle numérique (36) et ledit DAC à étages multiples (42).

5. Procédé selon la revendication 3, dans lequel ledit filtre à boucle numérique (36) est constitué d'un compteur haut/bas (36A), et dans lequel ledit DAC à étages multiples est constitué d'un DAC de commande de courant à étages multiples.

6. Procédé selon la revendication 1, comprenant en outre une étape de décimation de la sortie numérique dudit écoulement de courant à boucle fermée.

7. Circuit pour utilisation dans le chargement d'une batterie, comprenant
un transistor (2) pour fournir, au niveau d'un premier noeud (N1), un courant de charge de batterie I_{charge} pour charger la batterie ;
un circuit de réplication pour générer, au niveau d'un deuxième noeud (N2), un courant Iᵣₑₚ répliqué à partir d'I_{charge}, où Iᵣₑₚ < I_{charge} ; et
un écoulement de courant à boucle fermée pour écouler Iᵣₑₚ, où une sortie numérique dudit écoulement de courant à boucle fermée est une mesure de l'amplitude d'I_{charge} ;
dans lequel l'écoulement de courant à boucle fermée comprend une résistance de mesure (Rₘₑₐₛ₂) aux bornes de laquelle une chute de tension (Vₘₑₐₛ₂) due à une circulation de courant Iᵣₑₚ dans ladite résistance de mesure est mesurée.

8. Circuit selon la revendication 7, dans lequel ladite sortie numérique est délivrée en entrée à un circuit de commande pour commander la génération d'I_{charge}.

9. Circuit selon la revendication 7, dans lequel ledit écoulement de courant à boucle fermée est constitué d'un DAC à étages multiples (42) entraîné par des sorties d'un filtre à boucle numérique (36) ayant une sortie qui incrémente ou décrémente en fonction d'une différence de tension entre ledit premier noeud (N1) et ledit deuxième noeud (N2).

10. Circuit selon la revendication 9, dans lequel une sélection d'étages du DAC à étages multiples (42) devant être mis hors service et en service est effectuée par un bloc logique d'adaptation d'élément dynamique DEM (40) qui est interposé entre la sortie dudit filtre à boucle numérique et ledit DAC à étages multiples (42).

11. Circuit selon la revendication 9, dans lequel ledit filtre à boucle numérique (36) est constitué d'un compteur haut/bas (36A), et dans lequel ledit DAC à étages multiples est constitué d'un DAC de commande de courant à étages multiples.

12. Circuit selon la revendication 7, comprenant en outre un filtre de décimation (38) couplé à ladite sortie numérique dudit écoulement de courant à boucle fermée.

13. Circuit selon la revendication 9, comprenant en outre un filtre ayant une entrée différentielle couplée auxdits premier et deuxième noeuds, ledit filtre comprenant l'une parmi une sortie asymétrique et une sortie différentielle couplée à une entrée d'un comparateur, ledit comparateur ayant une sortie couplée à une entrée dudit filtre à boucle numérique.
